# EUROPEAN PATENT APPLICATION

(11) **EP 4 607 279 A1**
(43) Date of publication of application: **27.08.2025**
(21) Application number: 22969272.8
(22) Date of filing: 23.12.2022
(51) Int. Cl.: G03F 7/004, G03F 7/033, G03F 7/031

(54) **PHOTOSENSITIVE RESIN COMPOSITION, PHOTOSENSITIVE ELEMENT, METHOD FOR FORMING RESIST PATTERN, AND METHOD FOR PRODUCING PRINTED WIRING BOARD**

(71) Applicant: Resonac Corporation, Tokyo 105-7325 (JP)
(72) Inventor: TODA, Natsuki, Tokyo 105-7325 (JP); SAWAKI, Taku, Tokyo 105-7325 (JP); YOSHIHARA, Kensuke, Tokyo 105-7325 (JP); KAGUCHI, Yosuke, Tokyo 105-7325 (JP); YUI, Motoaki, Tokyo 105-7325 (JP)
(74) Representative: Berggren Oy
(86) International application number: PCT/JP2022/047694
(87) International publication number: WO 2024/134889

(57) **Abstract**

A photosensitive resin composition of the present disclosure contains a binder polymer, a photopolymerizable compound, a photopolymerization initiator, and a sensitizer, in which the binder polymer has a structural unit derived from an acrylic acid and a structural unit derived from styrene or a styrene derivative, and a content of the sensitizer is 1.60 parts by mass or less with respect to 100 parts by mass of the photopolymerization initiator.

## Description

### Technical Field

The present disclosure relates to a photosensitive resin composition, a photosensitive element, a method for forming a resist pattern, and a method for producing a printed wiring board.

### Background Art

In the field of production of printed wiring boards, photosensitive resin compositions and photosensitive elements including a layer formed using a photosensitive resin composition (hereinafter, also referred to as "photosensitive layer") on a support film, have been widely used as resist materials used for an etching treatment, a plating treatment, or the like.

A printed wiring board is produced using the above-described photosensitive element, for example, by the following procedure. That is, first, a photosensitive layer of a photosensitive element is laminated on a substrate for circuit formation such as a copper-clad laminate plate. Next, the photosensitive layer is exposed through a mask film or the like to form a photo-cured area. At this time, a support film is released before exposure or after exposure. Thereafter, an area other than the photo-cured area of the photosensitive layer is removed with a developing solution to form a resist pattern. Next, the substrate is subjected to an etching treatment or a plating treatment using the resist pattern as a resist to form a conductor pattern, and finally, the photo-cured area (resist pattern) of the photosensitive layer is released (removed).

With increasingly high density of printed wiring boards, as miniaturization of conductor patterns proceeds, a contact area between the substrate for circuit formation and the photosensitive layer as the resist becomes smaller. Therefore, the photosensitive layer is required to have excellent characteristics in an etching treatment or a plating treatment and is required to have excellent adhesiveness with the substrate for circuit formation and excellent resolution in formation of the resist pattern (see, for example, Patent Literatures 1 and 2).

### Citation List

### Patent Literature

Patent Literature 1: JP 2009-003177 A
Patent Literature 2: JP 2013-195712 A

### Summary of Invention

### Technical Problem

With improved performances of semiconductor packages, the smoothness of the substrate proceeds, the photosensitive resin composition is required to form a resist pattern having high adhesiveness with respect to a smooth substrate having a surface roughness (Ra) of 200 nm or less. On the other hand, in the photosensitive resin composition excellent in adhesiveness, the developing time of the photosensitive layer and the release time of the resist pattern become easily longer. From the viewpoint of improving productivity, it is developing to shorten the developing time and the release time in the photosensitive resin composition.

An object of the present disclosure is to provide a photosensitive resin composition excellent in developability, adhesiveness, and release property, a photosensitive element, a method for forming a resist pattern, and a method for producing a printed wiring board.

### Solution to Problem

The present inventors have conducted intensive studies focusing on the composition of the binder polymer and the content of the sensitizer in order to solve the above-described problems, and have found a photosensitive resin composition capable of forming a resist pattern excellent in adhesiveness with respect to a smooth substrate and capable of shortening the developing time of a photosensitive layer and the release time of a resist pattern. One aspect of the present disclosure relates to a photosensitive resin composition, a photosensitive element, a method for forming a resist pattern, and a method for producing a printed wiring board described below.
[1] A photosensitive resin composition containing: a binder polymer; a photopolymerizable compound; a photopolymerization initiator; and a sensitizer, in which the binder polymer has a structural unit derived from an acrylic acid and a structural unit derived from styrene or a styrene derivative, and a content of the sensitizer is 1.60 parts by mass or less with respect to 100 parts by mass of the photopolymerization initiator.
[2] The photosensitive resin composition described in [1], in which the sensitizer contains a pyrazoline compound or a dialkylaminobenzophenone compound.
[3] The photosensitive resin composition described in [1] or [2], in which a weight average molecular weight of the binder polymer is 10000 to 60000.
[4] The photosensitive resin composition described in any of [1] to [3], in which an acid value of the binder polymer is 140 to 200 mgKOH/g.
[5] The photosensitive resin composition described in any of [1] to [4], in which a content of the structural unit derived from styrene or a styrene derivative is 50 to 85% by mass on the basis of a total mass of structural units derived from polymerizable monomers constituting the binder polymer.
[6] A photosensitive element including: a support; and a photosensitive layer formed using the photosensitive resin composition described in any of [1] to [5] on the support.
[7] A method for forming a resist pattern, the method including: a step of forming a photosensitive layer using the photosensitive resin composition described in any of [1] to [5] or the photosensitive element described in
[6] on a substrate; a step of irradiating at least a part of the photosensitive layer with an active light ray to form a photo-cured area; and a step of removing a non-photo-cured area of the photosensitive layer from the substrate to form a resist pattern.
[8] A method for producing a printed wiring board, the method including a step of subjecting a substrate having a resist pattern formed by the method for forming a resist pattern described in [7] to an etching treatment or a plating treatment to form a conductor pattern.
[9] The method for producing a printed wiring board described in [8], further including a step of removing the resist pattern after the etching treatment or the plating treatment.

### Advantageous Effects of Invention

According to the present disclosure, it is possible to provide a photosensitive resin composition excellent in developability, adhesiveness, and release property, a photosensitive element, a method for forming a resist pattern, and a method for producing a printed wiring board.

### Brief Description of Drawings

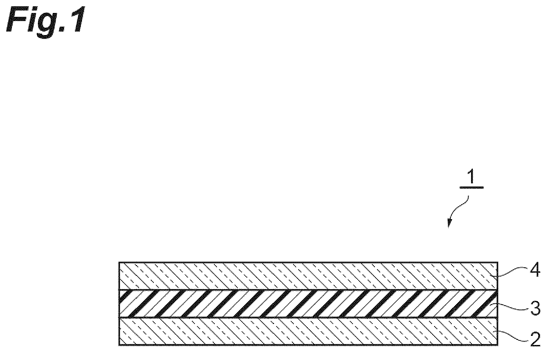

[FIG. 1] FIG. 1 is a schematic cross-sectional view illustrating an embodiment of a photosensitive element.

### Description of Embodiments

In the present specification, the term "step" includes not only an independent step but also a step by which an intended action of the step is achieved, even though the step cannot be clearly distinguished from other steps. The term "layer" includes a structure having a shape which is formed on a part, in addition to a structure having a shape which is formed on the whole surface, when the layer has been observed as a plan view. A numerical range that has been indicated by use of "to" indicates the range that includes the numerical values which are described before and after "to", as the minimum value and the maximum value, respectively. In the numerical ranges that are described stepwise in the present specification, the upper limit value or the lower limit value of a numerical range of a certain stage may be substituted by the upper limit value or the lower limit value of a numerical range of another stage. In a numerical range described in the present specification, the upper limit value or the lower limit value of the numerical range may be substituted by a value disclosed in the Examples.

In the present specification, the term "(meth)acrylate" means at least one of "acrylate" and "methacrylate" corresponding thereto. The same applies to other analogous expressions such as (meth)acryloyl.

In the present specification, when a plurality of substances corresponding to each component exist in the composition, the amount of each component in the photosensitive resin composition means the total amount of the plurality of substances that exist in the composition, unless otherwise specified. In the present specification, the term "solid content" refers to a non-volatile content of a photosensitive resin composition excluding volatile substances (such as water and a solvent). That is, the term "solid content" refers to a component other than a solvent, remaining without volatile in drying of the photosensitive resin composition described below and also includes a component in a liquid, syrupy, or waxy state at room temperature (25°C).

### [Photosensitive resin composition]

A photosensitive resin composition of the present embodiment contains (A) a binder polymer (hereinafter, referred to as "component (A)" in some cases), (B) a photopolymerizable compound (hereinafter, referred to as "component (B)" in some cases), (C) a photopolymerization initiator (hereinafter, referred to as "component (C)" in some cases), and (D) a sensitizer (hereinafter, referred to as "component (D)" in some cases). The binder polymer has a structural unit derived from an acrylic acid and a structural unit derived from styrene or a styrene derivative. A content of the sensitizer in the photosensitive resin composition is 1.60 parts by mass or less with respect to 100 parts by mass of the photopolymerization initiator. Hereinafter, each component that the photosensitive resin composition may contain will be described in detail.

### (Component (A): binder polymer)

When the photosensitive resin composition of the present embodiment contains a binder polymer having a specific structure as the component (A), the developability, resolution, adhesiveness, and release property of a photosensitive layer formed from the photosensitive resin composition can be improved.

The component (A) can be produced by radical polymerization of polymerizable monomers containing an acrylic acid and styrene or a styrene derivative.

When the component (A) has a structural unit derived from an acrylic acid, the alkali developability of the photosensitive resin composition is improved, and the release property of the resist pattern can be improved. An acrylic acid and a methacrylic acid may be used in combination, but when the content of a structural unit derived from a methacrylic acid is increased, the release property is likely to be deteriorated.

The content of the structural unit derived from an acrylic acid in the component (A) is preferably 15% by mass or more, and may be 16% or more, 17% by mass or more, 18% by mass or more, or 20% by mass or more, on the basis of the total mass (100% by mass) of structural units derived from polymerizable monomers constituting the binder polymer, from the viewpoint of further shortening the developing time. The content of the structural unit derived from an acrylic acid is preferably 26% by mass or less and may be 25% by mass or less, 24% by mass or less, or 23% by mass or less, from the viewpoint of further improving adhesiveness. The content of the structural unit derived from an acrylic acid may be 15 to 26% by mass, 16 to 25% by mass, 17 to 24% by mass, 18 to 24% by mass, or 20 to 23% by mass, from the viewpoint of improving developability and adhesiveness in a well-balanced manner.

When the component (A) has a structural unit derived from styrene or a styrene derivative (hereinafter, also referred to as "styrene-based structural unit"), the resolution and adhesiveness of the photosensitive resin composition can be improved. Examples of the styrene derivative include vinyl toluene, α-methylstyrene, p-methylstyrene, and p-ethylstyrene.

The content of the styrene-based structural unit in the component (A) may be 50% by mass or more, 55% by mass or more, 60% by mass or more, or 65% by mass or more, on the basis of the total mass of structural units derived from polymerizable monomers constituting the binder polymer, from the viewpoint of further improving adhesiveness. The content of the styrene-based structural unit may be 85% by mass or less, 84% by mass or less, 83% by mass or less, or 80% by mass or less, from the viewpoint of further shortening the release time. From the viewpoint of improving adhesiveness and release property in a well-balanced manner, the content of the styrene-based structural unit may be 50 to 85% by mass, 55 to 84% by mass, 60 to 83% by mass, or 65 to 80% by mass.

The component (A) may further have a structural unit derived from a (meth)acrylate compound having an alicyclic structure. By having the structural unit derived from a (meth)acrylate compound having an alicyclic structure, the resolution and adhesiveness of the photosensitive resin composition can be improved. Examples of the (meth)acrylate having an alicyclic structure include cyclohexyl (meth)acrylate, isobornyl (meth)acrylate, adamantyl (meth)acrylate, cyclopentanyl (meth)acrylate, and dicyclopentanyl (meth)acrylate.

The content of the structural unit derived from a (meth)acrylate compound having an alicyclic structure may be 1% by mass or more, 2% by mass or more, or 4% by mass or more from the viewpoint of further improving the resolution and adhesiveness of the photosensitive resin composition, and may be 15% by mass or less, 10% by mass or less, or 8% by mass or less from the viewpoint of further improving the developability of the photosensitive resin composition, on the basis of the total mass (100% by mass) of structural units derived from polymerizable monomers constituting the binder polymer.

The component (A) may further include structural units derived from polymerizable monomers (hereinafter, also referred to as "other monomers") other than the above. Examples of the other monomers include methacrylic acid, 2-ethylhexyl (meth)acrylate, hydroxyethyl (meth)acrylate, benzyl (meth)acrylate or a derivative thereof, furfuryl (meth)acrylate, tetrahydrofurfuryl (meth)acrylate, dimethylaminoethyl (meth)acrylate, diethylaminoethyl (meth)acrylate, glycidyl (meth)acrylate, 2,2,2-trifluoroethyl (meth)acrylate, 2,2,3,3-tetrafluoropropyl (meth)acrylate, β-furyl (meth)acrylic acid, β-styryl (meth)acrylic acid, maleic acid, maleic anhydride, maleic acid monoalkyl ester, fumaric acid, cinnamic acid, α-cyanocinnamic acid, itaconic acid, crotonic acid, and propiolic acid. These can be used singly or in combination of two or more kinds thereof.

The weight average molecular weight (Mw) of the component (A) may be 10000 to 60000, 15000 to 55000, 20000 to 50000, or 23000 to 45000. When the Mw is 60000 or less, there is a tendency that resolution and developability are further improved, and when the Mw is 10000 or more, there is a tendency that chipping and peeling of the resist pattern are difficult to occur. The degree of dispersion (Mw/Mn) of the component (A) may be 1.0 to 3.0, 1.0 to 2.5, or 1.0 to 2.3. When the degree of dispersion is decreased, there is a tendency that resolution is improved.

The weight average molecular weight and the degree of dispersion can be measured, for example, by gel permeation chromatography (GPC) using a calibration curve of standard polystyrene. More specifically, it is possible to measure under conditions described in Examples.

The acid value of the component (A) may be 140 to 200 mgKOH/g, 150 to 190 mgKOH/g, or 160 to 180 mgKOH/g, from the viewpoint of achieving both developability and release property. When the acid value of the component (A) is 140 mgKOH/g or more, it is easy to further shorten the developing time, and when the acid value thereof is 200 mgKOH/g or less, it is easy to further improve adhesiveness. The acid value of the component (A) can be adjusted by the structural unit derived from an acrylic acid. The acid value of the component (A) can be measured according to JIS K 6901:2008 5.3.2.

The content of the component (A) may be 20 parts by mass or more, 30 parts by mass or more, 40 parts by mass, or 50 parts by mass or more from the viewpoint of excellent film moldability, and may be 80 parts by mass or less, 70 parts by mass or less, or 60 parts by mass or less from the viewpoint of further improving sensitivity and resolution, with respect to 100 parts by mass of the total amount of the component (A) and the component (B).

### (Component (B): photopolymerizable compound)

The component (B) is not particularly limited as long as it has at least one ethylenically unsaturated bond and is a photopolymerizable compound. From the viewpoint of improving alkali developability, resolution, and peeling property after curing, the component (B) preferably includes at least one of bisphenol-type (meth)acrylates, and more preferably includes a bisphenol A-type (meth)acrylate among the bisphenol-type (meth)acrylates.

Examples of the bisphenol A-type (meth)acrylate include 2,2-bis(4-((meth)acryloxypolyethoxy)phenyl)propane, 2,2-bis(4-((meth)acryloxypolypropoxy)phenyl)propane, 2,2-bis(4-((meth)acryloxypolybutoxy)phenyl)propane, and 2,2-bis(4-((meth)acryloxypolyethoxypolypropoxy)phenyl)propane. Of these, from the viewpoint of further improving resolution and release property, 2,2-bis(4-((meth)acryloxypolyethoxy)phenyl)propane is preferred.

As the 2,2-bis(4-((meth)acryloxypolyethoxy)phenyl)propane, a compound in which the number of oxyethylene groups is 10 or more may be used, a compound in which the number of oxyethylene groups is less than 10 may be used, and a compound in which the number of oxyethylene groups is 10 or more and a compound in which the number of oxyethylene groups is less than 10 may be used in combination.

Examples of commercially available products of the bisphenol A-type (meth)acrylate include BPE-200 (manufactured by SHIN-NAKAMURA CHEMICAL Co., Ltd., trade name) as 2,2-bis(4-((meth)acryloxydipropoxy)phenyl)propane, BP-2EM (manufactured by Kyoeisha Chemical Co., Ltd., trade name) as ethoxylated bisphenol A dimethacrylate, and BPE-500 (manufactured by SHIN-NAKAMURA CHEMICAL Co., Ltd., trade name) and FA-321M (manufactured by Showa Denko Materials Co., Ltd., trade name) as 2,2-bis(4-(methacryloxypentaethoxy)phenyl)propane. These bisphenol A-type (meth)acrylates may be used singly or in combination of two or more kinds thereof.

The content of the bisphenol-type (meth)acrylate may be 40 to 98% by mass, 50 to 97% by mass, 60 to 95% by mass, or 70 to 90% by mass, on the basis of the total amount of the component (B). When this content is 40% by mass or more, resolution, adhesiveness, and repressibility of occurrence of resist footing become more favorable, and when this content is 98% by mass or less, the developing time is moderately shortened and development residues are more difficult to occur.

From the viewpoint of improving the flexibility of a cured product (cured film), the component (B) other than the bisphenol-type (meth)acrylate may further include at least one of polyalkylene glycol di(meth)acrylates having at least one of a (poly)oxyethylene chain and a (poly)oxypropylene chain in the molecule, and may further include a polyalkylene glycol di(meth)acrylate having both of a (poly)oxyethylene chain and a (poly)oxypropylene chain in the molecule. The total number of the oxyethylene groups (EO groups) and/or the oxypropylene groups (PO groups) of the polyalkylene glycol di(meth)acrylate may be 2 to 40, 4 to 30, or 6 to 20 from the viewpoint of further improving adhesiveness and resolution.

Examples of the polyalkylene glycol di(meth)acrylate include FA-023M (manufactured by Showa Denko Materials Co., Ltd., trade name), FA-024M (manufactured by Showa Denko Materials Co., Ltd., trade name), and NK ESTETR HEMA-9P (manufactured by SHIN-NAKAMURA CHEMICAL Co., Ltd., trade name). These may be used singly or in combination of two or more kinds thereof.

The content of the polyalkylene glycol di(meth)acrylate may be 2 to 40% by mass, 3 to 30% by mass, or 5 to 20% by mass, on the basis of the total amount of the component (B).

As the component (B) other than the above, a nonylphenoxypolyethylene oxyacrylate, a phthalic acid-based compound, a polyol (meth)acrylate ester, an alkyl (meth)acrylate ester, and the like may be used. Of these, from the viewpoint of improving resolution, adhesiveness, and peeling property after resist formation and curing in a well-balanced manner, the component (B) may include at least one selected from a nonylphenoxypolyethylene oxyacrylate and a phthalic acid-based compound. However, since the refractive indices of these compounds are relatively low, from the viewpoint of improving resolution, the content thereof may be 5 to 50% by mass, 5 to 40% by mass, or 10 to 30% by mass, on the basis of the total amount of the component (B).

Examples of the nonylphenoxypolyethylene oxyacrylate include nonylphenoxytriethylene oxyacrylate, nonylphenoxytetraethylene oxyacrylate, nonylphenoxypentaethylene oxyacrylate, nonylphenoxyhexaethylene oxyacrylate, nonylphenoxyheptaethylene oxyacrylate, nonylphenoxyoctaethylene oxyacrylate, nonylphenoxynonaethylene oxyacrylate, nonylphenoxydecaethylene oxyacrylate, and nonylphenoxyundecaethylene oxyacrylate.

Examples of the phthalic acid-based compound include γ-chloro-β-hydroxypropyl-β'-(meth)acryloyloxyethyl-o-phthalate, β-hydroxyethyl-β'-(meth)acryloyloxyethyl-o-phthalate, and β-hydroxypropyl-β'-(meth)acryloyloxyethyl-o-phthalate. The γ-chloro-β-hydroxypropyl-β'-methacryloyloxyethyl-o-phthalate is commercially available as FA-MECH (manufactured by Showa Denko Materials Co., Ltd., trade name).

From the viewpoint of improving sensitivity and reducing footing trailing, the component (B) may include a polyol (meth)acrylate ester. Examples of the polyol (meth)acrylate ester include trimethylol propane polyethoxy tri(meth)acrylate, trimethylol propane polypropoxy tri(meth)acrylate, trimethylol propane polybutoxy tri(meth)acrylate, trimethylol propane polyethoxy polypropoxy tri(meth)acrylate, trimethylolethane polyethoxy tri(meth)acrylate, trimethylolethane polypropoxy tri(meth)acrylate, trimethylolethane polybutoxy tri(meth)acrylate, trimethylolethane polyethoxy polypropoxy tri(meth)acrylate, pentaerythritol polyethoxy tri(meth)acrylate, pentaerythritol polypropoxy tri(meth)acrylate, pentaerythritol polybutoxy tri(meth)acrylate, pentaerythritol polyethoxy polypropoxy tri(meth)acrylate, glyceryl polyethoxy tri(meth)acrylate, glyceryl polypropoxy tri(meth)acrylate, glyceryl polybutoxy tri(meth)acrylate, and glyceryl polyethoxy polypropoxy tri(meth)acrylate.

The content of the component (B) is set to preferably 20 to 60 parts by mass, more preferably 30 to 55 parts by mass, and further preferably 35 to 50 parts by mass, with respect to 100 parts by mass of the total amount of the component (A) and the component (B). When the content of the component (B) is in this range, photosensitivity and film coatability become more favorable in addition to the resolution and adhesiveness of the photosensitive resin composition.

### (Component (C): photopolymerization initiator)

The component (C) is not particularly limited as long as it is a component capable of polymerizing the component (B), and can be appropriately selected from photopolymerization initiators generally used.

Examples of the component (C) include a hexaarylbiimidazole compound; aromatic ketone compounds such as benzophenone, 2-benzyl-2-dimethylamino-1-(4-morpholinophenyl)-1-butanone, 2-(dimethylamino)-2-[(4-methylphenyl)methyl]-1-[4-(4-morpholinyl)phenyl]-1-butanone, 4-(2-hydroxyethoxy)phenyl-2-(hydroxy-2-propyl)ketone, and 2-methyl-1-[4-(methylthio)phenyl]-2-morpholino-propanone-1; quinone compounds such as alkylanthraquinone; benzoinether compounds such as benzoinalkyl ethers; benzoin compounds such as benzoin and alkylbenzoin; benzyl derivatives such as benzyldimethylketal; and phosphine oxide compounds such as bis(2,4,6-trimethylbenzoyl)-phenylphosphine oxide, bis(2,6-dimethylbenzoyl)-2,4,4-trimethyl-pentylphosphine oxide, and (2,4,6-trimethylbenzoyl)ethoxyphenylphosphine oxide.

From the viewpoint of improving the adhesiveness of the photosensitive layer with respect to a smooth substrate, the component (C) may contain a hexaarylbiimidazole compound. The aryl group in the hexaarylbiimidazole compound may be a phenyl group or the like. A hydrogen atom bonded to the aryl group in the hexaarylbiimidazole compound may be substituted with a halogen atom (a chlorine atom or the like)

The hexaarylbiimidazole compound may be a 2,4,5-triarylimidazole dimer. Examples of the 2,4,5-triarylimidazole dimer include a 2-(o-chlorophenyl)-4,5-diphenylimidazole dimer, a 2-(o-chlorophenyl)-4,5-bis-(m-methoxyphenyl)imidazole dimer, and a 2-(p-methoxyphenyl)-4,5-diphenylimidazole dimer.

The content of the component (C) may be 1.0 to 10 parts by mass, 2.0 to 8 parts by mass, 3.0 to 7.0 parts by mass, or 4.0 to 6.0 parts by mass, with respect to 100 parts by mass of the total amount of the component (A) and the component (B). When the content of the component (C) is in this range, both photosensitivity and resolution are easily improved in a well-balanced manner.

### (Component (D): sensitizer)

When the photosensitive resin composition of the present embodiment contains the component (D), the absorption wavelength of active light rays used for exposure can be effectively utilized.

Examples of the component (D) include a dialkylaminobenzophenone compound, a pyrazoline compound, an anthracene compound, a coumarin compound, a xanthone compound, a thioxanthone compound, an oxazole compound, a benzoxazole compound, a thiazole compound, a benzothiazole compound, a triazole compound, a stilbene compound, a triazine compound, a thiophene compound, a naphthalimide compound, a triarylamine compound, and an aminoacridine compound. From the viewpoint of further improving resolution and adhesiveness, the component (D) may contain a pyrazoline compound or a dialkylaminobenzophenone compound.

Examples of the pyrazoline compound include 1-(4-methoxyphenyl)-3-styryl-5-phenyl-pyrazoline, 1-phenyl-3-(4-methoxystyryl)-5-(4-methoxyphenyl)-pyrazoline, 1,5-bis-(4-methoxyphenyl)-3-(4-methoxystyryl)-pyrazoline, 1-(4-isopropylphenyl)-3-styryl-5-phenyl-pyrazoline, 1-phenyl-3-(4-isopropylstyryl)-5-(4-isopropylphenyl)-pyrazoline, 1,5-bis-(4-isopropylphenyl)-3-(4-isopropylstyryl)-pyrazoline, 1-(4-methoxyphenyl)-3-(4-tert-butyl-styryl)-5-(4-tert-butyl-phenyl)-pyrazoline, 1-(4-tert-butyl-phenyl)-3-(4-methoxystyryl)-5-(4-methoxyphenyl)-pyrazoline, 1-(4-isopropyl-phenyl)-3-(4-tert-butyl-styryl)-5-(4-tert-butyl-phenyl)-pyrazoline, 1-(4-tert-butyl-phenyl)-3-(4-isopropyl-styryl)-5-(4-isopropyl-phenyl)-pyrazoline, 1-(4-methoxyphenyl)-3-(4-isopropylstyryl)-5-(4-isopropylphenyl)-pyrazoline, 1-(4-isopropyl-phenyl)-3-(4-methoxystyryl)-5-(4-methoxyphenyl)-pyrazoline, 1-phenyl-3-(3,5-dimethoxystyryl)-5-(3,5-dimethoxyphenyl)-pyrazoline, 1-phenyl-3-(3,4-dimethoxystyryl)-5-(3,4-dimethoxyphenyl)-pyrazoline, 1-phenyl-3-(2,6-dimethoxystyryl)-5-(2,6-dimethoxyphenyl)-pyrazoline, 1-phenyl-3-(2,5-dimethoxystyryl)-5-(2,5-dimethoxyphenyl)-pyrazoline, 1-phenyl-3-(2,3-dimethoxystyryl)-5-(2,3-dimethoxyphenyl)-pyrazoline, 1-phenyl-3-(2,4-dimethoxystyryl)-5-(2,4-dimethoxyphenyl)-pyrazoline, 1-(4-methoxyphenyl)-3-(3,5-dimethoxystyryl)-5-(3,5-dimethoxyphenyl)-pyrazoline, 1-(4-methoxyphenyl)-3-(3,4-dimethoxystyryl)-5-(3,4-dimethoxyphenyl)-pyrazoline, 1-(4-methoxyphenyl)-3-(2,6-dimethoxystyryl)-5-(2,6-dimethoxyphenyl)-pyrazoline, 1-(4-methoxyphenyl)-3-(2,5-dimethoxystyryl)-5-(2,5-dimethoxyphenyl)-pyrazoline, 1-(4-methoxyphenyl)-3-(2,3-dimethoxystyryl)-5-(2,3-dimethoxyphenyl)-pyrazoline, 1-(4-methoxyphenyl)-3-(2,4-dimethoxystyryl)-5-(2,4-dimethoxyphenyl)-pyrazoline, 1-(4-tert-butyl-phenyl)-3-(3,5-dimethoxystyryl)-5-(3,5-dimethoxyphenyl)-pyrazoline, 1-(4-tert-butylphenyl)-3-(3,4-dimethoxystyryl)-5-(3,4-dimethoxyphenyl)-pyrazoline, 1-(4-tert-butyl-phenyl)-3-(2,6-dimethoxystyryl)-5-(2,6-dimethoxyphenyl)-pyrazoline, 1-(4-tert-butyl-phenyl)-3-(2,5-dimethoxystyryl)-5-(2,5-dimethoxyphenyl)-pyrazoline, 1-(4-tert-butylphenyl)-3-(2,3-dimethoxystyryl)-5-(2,3-dimethoxyphenyl)-pyrazoline, 1-(4-tert-butyl-phenyl)-3-(2,4-dimethoxystyryl)-5-(2,4-dimethoxyphenyl)-pyrazoline, 1-(4-isopropyl-phenyl)-3-(3,5-dimethoxystyryl)-5-(3,5-dimethoxyphenyl)-pyrazoline, 1-(4-isopropylphenyl)-3-(3,4-dimethoxystyryl)-5-(3,4-dimethoxyphenyl)-pyrazoline, 1-(4-isopropyl-phenyl)-3-(2,6-dimethoxystyryl)-5-(2,6-dimethoxyphenyl)-pyrazoline, 1-(4-isopropyl-phenyl)-3-(2,5-dimethoxystyryl)-5-(2,5-dimethoxyphenyl)-pyrazoline, 1-(4-isopropylphenyl)-3-(2,3-dimethoxystyryl)-5-(2,3-dimethoxyphenyl)-pyrazoline, and 1-(4-isopropyl-phenyl)-3-(2,4-dimethoxystyryl)-5-(2,4-dimethoxyphenyl)-pyrazoline.

Examples of the dialkylaminobenzophenone compound include 4,4'-bis(dimethylamino)benzophenone, 4,4'-bis(diethylamino)benzophenone, and 4-benzoyl-4'-methyldiphenyl sulfide.

The content of the component (D) may be 1.50 parts by mass or less, 1.40 parts by mass or less, or 1.35 parts by mass or less, with respect to 100 parts by mass of the component (C), from the viewpoint of further improving adhesiveness. The content of the component (D) may be 0.15 to 1.60 parts by mass, 0.20 to 1.50 parts by mass, 0.25 to 1.40 parts by mass, or 0.30 to 1.35 parts by mass, with respect to 100 parts by mass of the component (C), from the viewpoint of improving developability, adhesiveness, and release property in a well-balanced manner.

The content of the component (D) may be 0.01 to 0.10 parts by mass, 0.01 to 0.09 parts by mass, or 0.01 to 0.08 parts by mass, with respect to 100 parts by mass of the total amount of the component (A) and the component (B), from the viewpoint of improving photosensitivity and resolution.

### (Component (E): polymerization inhibitor)

The photosensitive resin composition may further contain a polymerization inhibitor as a component (E) from the viewpoint of suppressing the polymerization in an unexposed area at the time of forming a resist pattern and further improving resolution. Examples of the polymerization inhibitor include 4-tert-butylcatechol and 2,2,6,6-tetramethyl-4-hydroxypiperidine-1-oxyl.

The content of the component (E) may be 0.001 to 0.10 parts by mass, 0.005 to 0.08 parts by mass, or 0.01 to 0.06 parts by mass, with respect to 100 parts by mass of the total amount of the component (A) and the component (B).

### (Other components)

The photosensitive resin composition may further contain one or two or more kinds of other components which are other than the above-described components. Examples of the other components include a hydrogen donor (such as bis[4-(dimethylamino)phenyl]methane, bis[4-(diethylamino)phenyl]methane, leuco crystal violet, and N-phenylglycine), a dye (such as malachite green), tribromophenylsulfone, a photochromic agent, a thermal development inhibitor, a plasticizer (such as p-toluenesulfonamide), a pigment, a filler, an antifoaming agent, a flame retardant, a stabilizer, a tackifier, a leveling agent, a release promoter, an antioxidant, an aroma, an imaging agent, and a thermal crosslinking agent. The content of the other components may be 0.005 parts by mass or more or 0.01 parts by mass or more, and may be 20 parts by mass or less, with respect to 100 parts by mass of the total amount of the component (A) and the component (B).

In order to improve the handleability of the photosensitive composition or adjust the viscosity and the storage stability, the photosensitive resin composition can contain an organic solvent. As the organic solvent, an organic solvent to be generally used can be used without particular limitation. Examples of the organic solvent include methanol, ethanol, acetone, methyl ethyl ketone, methyl cellosolve, ethyl cellosolve, toluene, N,N-dimethylformamide, propylene glycol monomethyl ether, and mixed solvents thereof. For example, the components (A) to (D) are dissolved in an organic solvent and then the resultant solution can be used as a solution (hereinafter, referred to as "coating liquid") having a solid content of about 30 to 60% by mass. Note that, the solid content means a remaining component obtained by removing a volatile component from the solution of the photosensitive resin composition.

### [Photosensitive element]

A photosensitive element of the present embodiment includes a support and a photosensitive layer formed on the support, and the photosensitive layer contains the above-described photosensitive resin composition. In the case of using the photosensitive element of the present embodiment, the photosensitive layer may be laminated on a substrate and then may be exposed without the support (support film) being peeled off.

FIG. 1 is a schematic cross-sectional view of a photosensitive element according to an embodiment. As illustrated in FIG. 1, a photosensitive element 1 includes a support 2, and a photosensitive layer 3 derived from the above-described photosensitive resin composition formed on the support 2, and is configured by including other layers, such as a protective layer 4, which is provided as necessary.

Each of the support 2 and the protective layer 4 may be a polymer film having heat resistance and solvent resistance, and may be, for example, a polyester film such as a polyethylene terephthalate film, a polyolefin film such as a polyethylene film or a polypropylene film, and the like. Each of the support 2 and the protective layer 4 may be a film of a hydrocarbon-based polymer other than polyolefin. The hydrocarbon-based polymer film containing polyolefin may have a low density, or may have, for example, a density of 1.014 g/cm³ or less. Each of the support 2 and the protective layer 4 may be a stretched film obtained by stretching the low-density hydrocarbon-based polymer film. The type of the polymer film constituting the protective layer 4 may be the same as or different from the type of the polymer film constituting the support 2.

These polymer films each are commercially available, for example, as polyethylene terephthalate films such as PS series (for example, PS-25) manufactured by TEIJIN LIMITED, polyethylene films such as NF-15 manufactured by TAMAPOLY CO., LTD., or polypropylene films such as polypropylene films manufactured by Oji Paper Co., Ltd. (for example, ALPHAN MA-410 and E-200C) and polypropylene films manufactured by SHIN-ETSU FILM CO., LTD.

The thickness of the support 2 may be 1 µm or more or 5 µm or more from the viewpoint that breakage of the support 2 can be suppressed when the support 2 is peeled off from the photosensitive layer 3, and may be 100 µm or less, 50 µm or less, or 30 µm or less from the viewpoint that exposure can be suitably performed even in the case of exposure through the support 2.

The thickness of the protective layer 4 may be 1 µm or more, 5 µm or more, or 15 µm or more from the viewpoint that breakage of the protective layer 4 can be suppressed when the photosensitive layer 3 and the support 2 are laminated on the substrate while the protective layer 4 is peeled off, and may be 100 µm or less, 50 µm or less, or 30 µm or less from the viewpoint of improving productivity.

The photosensitive layer 3 is composed of the above-described photosensitive resin composition. The post-drying thickness of the photosensitive layer 3 (after an organic solvent is volatilized in a case where the photosensitive resin composition contains the organic solvent) may be 1 µm or more or 5 µm or more from the viewpoint of facilitating coating and improving productivity, and may be 100 µm or less, 50 µm or less, or 40 µm or less from the viewpoint of further improving adhesiveness and resolution.

The photosensitive element 1 can be obtained, for example, as follows. First, the photosensitive layer 3 is formed on the support 2. The photosensitive layer 3 can be formed, for example, by applying a photosensitive resin composition containing an organic solvent to form a coating layer and drying this coating layer. Next, the protective layer 4 is formed on a surface of the photosensitive layer 3 on a side opposite to the support 2.

The coating layer is formed, for example, by known methods such as roll coating, comma coating, gravure coating, air knife coating, die coating, and bar coating. The drying of the coating layer is performed so that the amount of the organic solvent remaining in the photosensitive layer 3 is, for example, 2% by mass or less, and specifically, is performed, for example, at 70 to 150°C for about 5 to 30 minutes.

The photosensitive element may further include an intermediate layer between the support 2 and the photosensitive layer 3 described above. The intermediate layer may be a layer containing a water-soluble resin. Examples of the water-soluble resin include a resin including polyvinyl alcohol as a main component.

In another embodiment, the photosensitive element may not include a protective layer, and may further include other layers such as a cushion layer, an adhesive layer, a light-absorbing layer, and a gas barrier layer.

The photosensitive element 1 may be, for example, in a sheet form, and may be in the form of a photosensitive element roll wound around a core into a roll. In the photosensitive element roll, the photosensitive element 1 is preferably wound such that the support 2 comes on the outer side. The core is formed, for example, with polyethylene, polypropylene, polystyrene, polyvinyl chloride, an acrylonitrile-butadiene-styrene copolymer, or the like. At end faces of the photosensitive element roll, end-face separators may be provided from the viewpoint of protecting the end faces, and moisture-proof end-face separators may be provided from the viewpoint of resistance to edge fusion. The photosensitive element 1 may be wrapped, for example, with a black sheet having low moisture permeability.

The photosensitive element 1 can be suitably used in formation of a resist pattern and can be particularly suitably used in a method for producing a printed wiring substrate described below.

### [Method for forming resist pattern]

A method for forming a resist pattern of the present embodiment includes a step (photosensitive layer formation step) of forming a photosensitive layer using the above-described photosensitive resin composition or the above-described photosensitive element, on a substrate, a step (exposure step) of irradiating at least a part (predetermined part) of the photosensitive layer with an active light ray to form a photo-cured area, and a step (development step) of removing at least a part of the non-photo-cured area from the substrate, and may include other steps as necessary. The resist pattern can be said to be a photo-cured product pattern or a relief pattern of the photosensitive resin composition. The method for forming a resist pattern can be said to be a method for producing a substrate with a resist pattern.

### (Photosensitive layer formation step)

As a method for forming the photosensitive layer on a substrate, for example, the above-described photosensitive resin composition may be applied and dried, or the photosensitive layer may be pressure-bonded on the above-described substrate while the photosensitive layer of the photosensitive element is heated after the protective layer is removed from the above-described photosensitive element. In the case of using the photosensitive element, a laminate including the substrate, the photosensitive layer, and the support, which are laminated in this order, is obtained. The above-described substrate is not particularly limited, and a substrate for circuit formation including an insulation layer and a conductor layer formed on the insulation layer, or a die pad (a base material for lead frame) such as an alloy base material is generally used.

The surface roughness (Ra) of the substrate may be 200 nm or less, 180 nm or less, or 160 nm or less from the viewpoint of suppressing halation due to unevenness of the substrate to improve resolution, and may be 10 nm or more, 30 nm or more, or 40 nm or more from the viewpoint of improving the adhesiveness of the resist pattern. From the viewpoint of maintaining a balance between resolution and adhesiveness, Ra may be 10 to 200 nm, 30 to 180 nm, or 40 to 160 nm.

In the case of using the photosensitive element, in view of the adhesiveness and the followability, the photosensitive layer formation step is preferably performed under reduced pressure. The heating of the photosensitive layer and/or the substrate during the pressure-bonding may be performed at a temperature of 70 to 130°C. The pressure-bonding may be performed at a pressure of about 0.1 to 1.0 MPa (about 1 to 10 kgf/cm²), but these conditions are appropriately selected as necessary. Note that, when the photosensitive layer is heated to 70 to 130°C, there is no need to preheat the substrate in advance, but the substrate can also be preheated in order to further improve the adhesiveness and the followability.

### (Exposure step)

In the exposure step, at least a part of the photosensitive layer formed on the substrate is irradiated with an active light ray, thereby photo-curing an area irradiated with the active light ray to form a latent image. At this time, in a case where the support is present on the photosensitive layer, the photosensitive layer can be irradiated with the active light ray through the support if this support is transparent to the active light ray, whereas in a case where the support blocks the active light ray, the photosensitive layer is irradiated with the active light ray after the support is removed.

Examples of the exposure method include a method of performing imagewise irradiation with an active light ray via a negative or positive mask pattern called artwork (mask exposure method). Furthermore, a method of performing imagewise irradiation with an active light ray by a projection exposure method may be adopted. Furthermore, a method of performing imagewise irradiation with an active light ray by a direct writing exposure method such as an LDI (Laser Direct Imaging) exposure method or a DLP (Digital Light Processing) exposure method may be adopted.

Known light sources can be used as a light source for the active light ray, and for example, a carbon arc lamp, a mercury vapor arc lamp, a high-pressure mercury lamp, a xenon lamp, a gas laser such as an argon laser, a solid-state laser such as a YAG laser, and a semiconductor laser, which efficiently emit ultraviolet rays or visible light, are used.

### (Development step)

In the development step, at least a part of the non-photo-cured area (other than the photo-cured area) of the above-described photosensitive layer is removed from the substrate, so that a resist pattern is formed on the substrate. In a case where the support is present on the photosensitive layer, after the support is removed, an area (also called an unexposed area) other than the photo-cured area is removed (developed). The development method includes wet development and dry development, and wet development is widely used.

In the case of the wet development, development is performed by a known development method using a developing solution corresponding to the photosensitive resin composition. Examples of the development method include methods using dipping, paddling, spraying, brushing, scrubbing, shaking immersion, and the like. From the viewpoint of improving resolution, a high-pressure spraying method may be used as the development method. Two or more kinds of these methods may be combined for the development.

The configuration of the developing solution is appropriately selected depending on the configuration of the above-described photosensitive resin composition. Examples of the developing solution include an alkaline aqueous solution and an organic solvent developing solution.

In view of being safe and stable and having good handleability, an alkaline aqueous solution may be used as the developing solution. Examples of the base of the alkaline aqueous solution to be used include alkali hydroxides such as hydroxides of lithium, sodium, or potassium; alkaline carbonates such as carbonates or bicarbonates of lithium, sodium, potassium, or ammonium; alkali metal phosphates such as potassium phosphate and sodium phosphate; alkali metal pyrophosphates such as sodium pyrophosphate and potassium pyrophosphate; borax, sodium metasilicate, tetramethylammonium hydroxide, ethanolamine, ethylenediamine, diethylene triamine, 2-amino-2-hydroxymethyl-1,3-propanediol, 1,3-diaminopropanol-2, and morpholine.

As the alkaline aqueous solution to be used for development, a 0.1 to 5% by mass dilute solution of sodium carbonate, a 0.1 to 5% by mass dilute solution of potassium carbonate, a 0.1 to 5% by mass dilute solution of sodium hydroxide, a 0.1 to 5% by mass dilute solution of sodium tetraborate, or the like can be used. The pH of the alkaline aqueous solution may be set in a range of 9 to 11, and the temperature thereof can be adjusted according to the alkali developability of the photosensitive layer. Into the alkaline aqueous solution, for example, a surfactant, an antifoaming agent, a small amount of an organic solvent for promoting development, or the like may be incorporated.

Examples of the organic solvent used for the alkaline aqueous solution include acetone, ethyl acetate, alkoxyethanol having an alkoxy group having 1 to 4 carbon atoms, ethyl alcohol, isopropyl alcohol, butyl alcohol, diethylene glycol monomethyl ether, diethylene glycol monoethyl ether, and diethylene glycol monobutyl ether.

Examples of the organic solvent used for the organic solvent developing solution include 1,1,1-trichloroethane, N-methyl-2-pyrrolidone, N,N-dimethylformamide, cyclohexanone, methyl isobutyl ketone, and γ-butyrolactone. It may be possible that water is added to these organic solvents within a range of 1 to 20% by mass for anti-flammability to prepare the organic solvent developing solution.

The method for forming a resist pattern in the present embodiment may include a step of further curing the resist pattern by heating at about 60 to 250°C or exposing at about 0.2 to 10 J/cm², as necessary, after the uncured area is removed in the development step.

### [Method for producing printed wiring board]

A method for producing a printed wiring board of the present embodiment includes a step of subjecting a substrate having a resist pattern formed by the above-described method for forming a resist pattern to an etching treatment or a plating treatment to form a conductor pattern, and may include other steps such as a resist pattern removing step as necessary.

In the plating treatment, the resist pattern formed on the substrate is used as a mask, and a conductor layer provided on the substrate is subjected to the plating treatment. After the plating treatment, a conductor pattern may be formed by removing the resist by the removal of the resist pattern described below and further etching the conductor layer covered by the resist. The plating treatment method may be either an electrolytic plating treatment or an electroless plating treatment, but may be an electroless plating treatment.

In the etching treatment, the resist pattern formed on the substrate is used as a mask, and the conductor layer formed on the substrate is removed by etching to form a conductor pattern. The etching treatment method is appropriately selected depending on the conductor layer to be removed. Examples of an etching solution include a cupric chloride solution, a ferric chloride solution, an alkali etching solution, and a hydrogen peroxide-based etching solution.

After the etching treatment or the plating treatment, the resist pattern on the substrate may be removed. The resist pattern can be removed by being peeled off, for example, with an aqueous solution of stronger alkalinity than the alkaline aqueous solution used in the development step. As the strong alkaline aqueous solution, for example, a 1 to 10% by mass sodium hydroxide aqueous solution, a 1 to 10% by mass potassium hydroxide aqueous solution, and the like are used.

In a case where the resist pattern is removed after the plating treatment, a desired printed wiring board can be produced by further subjecting the conductor layer covered by the resist to the etching treatment to form a conductor pattern. The etching treatment method at this time is appropriately selected depending on the conductor layer to be removed. For example, the above-described etching solution can be applied.

The method for producing a printed wiring board of the present embodiment can be applied not only to production of single-layer printed wiring boards but also to production of multilayer printed wiring boards, and can also be applied to production of printed wiring boards having small diameter through-holes, and the like.

### Examples

Hereinafter, the present disclosure will be further specifically described by means of Examples; however, the present invention is not limited to these Examples.

### ((A) Binder polymer)

Solutions of binder polymers (A-1) to (A-5) shown in Table 1 were produced by the following procedure.

### (A-1)

A mixture (x) was prepared by mixing 96.1 g of acrylic acid (AA) and 339.9 g of styrene (ST) (mass ratio of AA/ST = 22.0/78.0) as polymerizable monomers, 4.6 g of tert-butylperoxy-2-ethylhexanoate (manufactured by NOF CORPORATION, trade name "PERBUTYL (registered trademark) O") as a thermal radical polymerization initiator, and 128.6 g of propylene glycol monomethyl ether as a solvent. A solution (a) was prepared by dissolving 4.4 g of PERBUTYL O in 37.4 g of propylene glycol monomethyl ether.

To a flask equipped with a stirrer, a dropping funnel, a condenser, a thermometer, and a gas inlet tube, 46.2 g of propylene glycol monomethyl ether and 174.8 g of toluene were added, stirred in a nitrogen atmosphere while replacing with gas, and heated to 98°C. Next, the mixture (x) was added dropwise into the flask over 2 hours. After the dropwise addition, stirring was performed at 98°C for 2 hours, and the solution (a) was added and further stirred for 3 hours. Next, while continuing stirring, the solution in the flask was heated to 105°C over 20 minutes, and then stirred at 105°C for 2 hours. Next, 93.8 g of propylene glycol monomethyl ether and 74.2 g of toluene were added and cooled to room temperature with stirring to obtain a solution of a binder polymer (A-1).

### (A-2)

A solution of a binder polymer (A-2) was obtained under the same conditions as in (A-1), except that the polymerizable monomers of the mixture (x) were changed to 99.8 g of acrylic acid (AA) and 336.3 g of styrene (ST) (mass ratio of AA/ST = 22.9/77.1).

### (A-3)

A solution of a binder polymer (A-3) was obtained under the same conditions as in (A-1), except that the polymerizable monomers of the mixture (x) were changed to 99.6 g of acrylic acid (AA), 306.2 g of styrene (ST), and 29.4 g of dicyclopentanyl methacrylate (TCDMA) (mass ratio of AA/ST/TCDMA = 22.9/70.3/6.8), and the amount of PERBUTYL O was changed to 5.5 g.

### (A-4)

A solution of a binder polymer (A-4) was obtained under the same conditions as in (A-3), except that the amount of PERBUTYL O of the mixture (x) was changed to 11.5 g.

### (A-5)

A solution of a binder polymer (A-5) was obtained under the same conditions as in (A-1), except that the polymerizable monomers of the mixture (x) were changed to 117.1 g of methacrylic acid (MMA), 283.0 g of styrene (ST), and 29.0 g of dicyclopentanyl methacrylate (TCDMA) (mass ratio of MAA/ST/TCDMA = 27.3/66.0/6.7), and the amount of PERBUTYL O was changed to 11.6 g.

### (Weight average molecular weight)

As a sample for Mw measurement, a 0.2% by mass THF solution was prepared by dissolving a binder polymer in tetrahydrofuran (THF). The Mw was measured by gel permeation chromatography (GPC) and was derived by conversion using a calibration curve of standard polystyrene. GPC conditions are shown below.
Measurement apparatus: Shodex (registered trademark) GPC-101 (manufactured by Showa Denko K.K.)
Detector: Differential refractometer Shodex RI-71S (manufactured by Showa Denko K.K.)
Column: Shodex LF-804 + LF-804 (manufactured by Showa Denko K.K.)
Column temperature: 40°C
Eluent: Tetrahydrofuran (THF)
Flow rate: 1 mL/min

### (Acid value)

The acid value of the binder polymer was measured by a neutralization titration method according to JIS K 6901:2008 5.3.2.

**[Table 1]**

| Binder polymer | Mass ratio of monomer | | | | Mw | Acid value (mgKOH/g) |
|---|---|---|---|---|---|---|
| | AA | MAA | ST | TCDMA | | |
| A-1 | 22.0 | - | 78.0 | - | 40580 | 167 |
| A-2 | 22.9 | - | 77.1 | - | 40620 | 173 |
| A-3 | 22.9 | - | 70.3 | 6.8 | 37810 | 174 |
| A-4 | 22.9 | - | 70.3 | 6.8 | 24330 | 170 |
| A-5 | - | 27.3 | 66.0 | 6.7 | 22200 | 172 |

### [Photosensitive resin composition]

With respect to 57 parts by mass of the binder polymer solution in terms of solid content amount, a photosensitive resin composition of Example was prepared by mixing respective components in the blending amounts (parts by mass) shown in Table 2, and a photosensitive resin composition of Comparative Example was prepared by mixing respective components in the blending amounts (parts by mass) shown in Table 3. The details of respective components shown in Tables 2 and 3 are as follows.

### ((B) Photopolymerizable compound)

B-1: 2,2-Bis(4-(methacryloxypentaethoxy)phenyl)propane (manufactured by Showa Denko Materials Co., Ltd., trade name "FA-321M", the number of EO groups: 10 (average value))
B-2: Ethoxylated bisphenol A dimethacrylate (manufactured by Kyoeisha Chemical Co., Ltd., trade name "BP-2EM", the number of EO groups: 2.6 (average value))
B-3: PO/EO/PO-modified dimethacrylate (manufactured by Showa Denko Materials Co., Ltd., trade name "FA-024M", the number of EO groups: 6 (average value), the number of PO groups: 12 (average value))

### ((C) Photopolymerization initiator)

C-1: 2,2'-Bis(2-chlorophenyl)-4,4',5,5'-tetraphenylbiimidazole (manufactured by Hampford Research Inc.)

### ((D) Sensitizer)

D-1: 1-Phenyl-3-(4-methoxystyryl)-5-(4-methoxyphenyl)-pyrazoline (manufactured by NIPPON CHEMICAL WORKS CO., LTD., trade name "PZ-501D")
D-2: 4,4'-Diethylaminobenzophenone (manufactured by Hodogaya Chemical Co., Ltd.)

### ((E) Polymerization inhibitor)

E-1: 4-tert-Butylcatechol (manufactured by DIC Corporation)
E-2: 2,2,6,6-Tetramethyl-4-hydroxypiperidine-1-oxyl (manufactured by ADEKA Corporation, trade name "LA-7RD")

### (Other components)

Tackifier: Mixture of carboxybenzotriazole, 5-amino-1H-tetrazole, and methoxypropanol (manufactured by SANWA KASEI CORP., trade name "SF-808H")
Photochromic agent: Leuco crystal violet (manufactured by Yamada Chemical Co., Ltd.)
Dye: Malachite green (manufactured by OSAKA ORGANIC CHEMICAL INDUSTRY LTD.)

### [Photosensitive element]

A polyethylene terephthalate film (manufactured by Toray Industries, Inc., trade name "FS-31") having a thickness of 16 µm was prepared as the support. The photosensitive resin composition was applied onto the support and dried for 10 minutes with a hot air convection drier set at 90°C to form a photosensitive layer having a post-drying thickness of 25 µm. Subsequently, a polyethylene film (manufactured by TAMAPOLY CO., LTD., trade name "NF-15A") as a protective layer was laminated on the photosensitive layer to obtain a photosensitive element in which the support, the photosensitive layer, and the protective layer were laminated in this order.

### [Laminate]

A substrate (Ra: 150 nm) with electroless copper plating on Ajinomoto Build-up Film (registered trademark) ABF (Ajinomoto Fine-Techno Co., Inc., trade name "GL-102") was heated to 80°C, and the photosensitive element was laminated on the copper surface of the substrate. The lamination was performed using a heat roll set at 110°C with a pressure-bonding pressure of 0.4 MPa and a roll speed of 1.0 m/min such that the photosensitive layer of the photosensitive element was in contact with the copper surface of the copper substrate, while the protective layer was peeled off. Thereby, a laminate in which the substrate, the photosensitive layer, and the support are laminated in this order was obtained. The obtained laminate was used as a test specimen for a test described below.

### (Minimum developing time)

The support was peeled off from the test specimen to expose the photosensitive layer and a 1% by mass sodium carbonate aqueous solution set at 30°C was sprayed. The time required for the photosensitive layer to be completely removed was measured and regarded as the minimum developing time.

### (Resolution and adhesiveness)

On the support of the test specimen, a glass chromium-type phototool (negative for resolution: one having a wiring pattern with a line width/space width of 3x/x (x: 1 to 10, unit: µm), negative for adhesiveness: one having a wiring pattern with a line width/space width of x/3x (x: 1 to 18, unit: µm)) was used as a negative for evaluation of resolution and adhesiveness, and the photosensitive layer was exposed at a predetermined energy dose by using a projection exposure apparatus (manufactured by Ushio Inc., trade name "UX-2240-SM-XJ01") equipped with an ultrahigh pressure mercury lamp (365 nm) as a light source. After exposure, the support was peeled off to expose the photosensitive layer, and a 1% by mass sodium carbonate aqueous solution set at 30°C was sprayed for two times the minimum developing time to remove the unexposed area (development treatment).

After the development treatment, the resolution and the adhesiveness were evaluated by the minimum value of the line width/space width among values of resist patterns in which space areas (unexposed areas) were removed without residues and line areas (exposed areas) were formed without twists, meandering, and defecting. At this time, values of the line width/space width in which the exposure dose at which the resist line width with a line width/space width = 10 µm/10 µm of the adhesiveness negative pattern was 10.0 µm was evaluated as the above-described predetermined energy dose, were recorded as the resolution and the adhesiveness. A smaller numerical value indicates more satisfactory resolution and adhesiveness.

### (Release time)

On the support of the test specimen, a glass chromium-type phototool (having a flat pattern of 50 mm × 40 mm) was used as a negative for release test evaluation, and the photosensitive layer was exposed at the above-described predetermined energy dose by using a projection exposure apparatus (manufactured by Ushio Inc., trade name "UX-2240-SM-XJ01") equipped with an ultrahigh pressure mercury lamp (365 nm) as a light source. After exposure, the support was peeled off to expose the photosensitive layer, and a 1% by mass sodium carbonate aqueous solution set at 30°C was sprayed for two times the minimum developing time to remove the unexposed area.

After the development treatment, the test specimen was immersed in an amine-based releasing solution heated to 50°C (15 vol% R-100S + 8 vol% R-101 aqueous solution, manufactured by MITSUBISHI GAS CHEMICAL COMPANY, INC.). The time required for the photosensitive layer to be completely removed was measured and regarded as the release time.

**[Table 2]**

| Example | | 1 | 2 | 3 | 4 | 5 | 6 | 7 |
|---|---|---|---|---|---|---|---|---|
| (A) | A-1 | 57.0 | - | - | - | 57.0 | 57.0 | 57.0 |
| | A-2 | - | 57.0 | - | - | - | - | - |
| | A-3 | - | - | 57.0 | - | - | - | - |
| | A-4 | - | - | - | 57.0 | - | - | - |
| (B) | B-1 | 34.5 | 34.5 | 34.5 | 34.5 | 34.5 | 34.5 | 34.5 |
| | B-2 | 6.0 | 6.0 | 6.0 | 6.0 | 6.0 | 6.0 | 6.0 |
| | B-3 | 2.5 | 2.5 | 2.5 | 2.5 | 2.5 | 2.5 | 2.5 |
| (C) | C-1 | 5.50 | 5.50 | 5.50 | 5.50 | 5.50 | 5.50 | 3.50 |
| (D) | D-1 | 0.027 | 0.027 | 0.027 | 0.027 | 0.072 | - | - |
| | D-2 | - | - | - | - | - | 0.019 | 0.043 |
| (E) | E-1 | 0.04 | 0.04 | 0.04 | 0.04 | 0.04 | 0.04 | 0.04 |
| | E-2 | 0.01 | 0.01 | 0.01 | 0.01 | 0.01 | 0.01 | 0.01 |
| Photochromic agent | | 0.77 | 0.77 | 0.77 | 0.77 | 0.77 | 0.77 | 0.77 |
| Tackifier | | 1.0 | 1.0 | 1.0 | 1.0 | 1.0 | 1.0 | 1.0 |
| Dye | | 0.05 | 0.05 | 0.05 | 0.05 | 0.05 | 0.05 | 0.05 |
| (D)/(C) × 100 | | 0.49 | 0.49 | 0.49 | 0.49 | 1.31 | 0.34 | 1.23 |
| Minimum developing time (sec) | | 22 | 23 | 22 | 23 | 22 | 22 | 20 |
| Adhesiveness (µm) | | 6 | 6 | 6.5 | 6.5 | 7 | 6 | 7 |
| Resolution (µm) | | 5 | 5 | 5 | 5 | 7 | 6 | 7 |
| Release time (sec) | | 21 | 18 | 18 | 18 | 21 | 21 | 20 |

**[Table 3]**

| Comparative Example | | 1 | 2 | 3 | 4 |
|---|---|---|---|---|---|
| (A) | A-1 | - | 57.0 | 57.0 | 57.0 |
| | A-5 | 57.0 | - | - | - |
| (B) | B-1 | 34.5 | 34.5 | 34.5 | 34.5 |
| | B-2 | 6.0 | 6.0 | 6.0 | 6.0 |
| | B-3 | 2.5 | 2.5 | 2.5 | 2.5 |
| (C) | C-1 | 5.50 | 5.50 | 5.50 | 2.90 |
| (D) | D-1 | 0.027 | 0.117 | 0.090 | - |
| | D-2 | - | - | - | 0.083 |
| (E) | E-1 | 0.04 | 0.04 | 0.04 | 0.04 |
| | E-2 | 0.01 | 0.01 | 0.01 | 0.01 |
| Photochromic agent | | 0.77 | 0.77 | 0.77 | 0.77 |
| Tackifier | | 1.0 | 1.0 | 1.0 | 1.0 |
| Dye | | 0.05 | 0.05 | 0.05 | 0.05 |
| (D)/(C) × 100 | | 0.49 | 2.13 | 1.64 | 2.86 |
| Minimum developing time (sec) | | 100 | 22 | 19 | 22 |
| Adhesiveness (µm) | | 6.5 | 11 | 9 | 9 |
| Resolution (µm) | | 5 | 11 | 9 | 9 |
| Release time (sec) | | 26 | 21 | 19 | 21 |

### Reference Signs List

1: photosensitive element, 2: support, 3: photosensitive layer, 4: protective layer.

## Claims

1. A photosensitive resin composition comprising: a binder polymer; a photopolymerizable compound; a photopolymerization initiator; and a sensitizer,
wherein the binder polymer has a structural unit derived from an acrylic acid and a structural unit derived from styrene or a styrene derivative, and
a content of the sensitizer is 1.60 parts by mass or less with respect to 100 parts by mass of the photopolymerization initiator.

2. The photosensitive resin composition according to claim 1, wherein the sensitizer contains a pyrazoline compound or a dialkylaminobenzophenone compound.

3. The photosensitive resin composition according to claim 1 or 2, wherein a weight average molecular weight of the binder polymer is 10000 to 60000.

4. The photosensitive resin composition according to any one of claims 1 to 3, wherein an acid value of the binder polymer is 140 to 200 mgKOH/g.

5. The photosensitive resin composition according to any one of claims 1 to 4, wherein a content of the structural unit derived from styrene or a styrene derivative is 50 to 85% by mass on the basis of a total mass of structural units derived from polymerizable monomers constituting the binder polymer.

6. A photosensitive element comprising: a support; and a photosensitive layer formed using the photosensitive resin composition according to any one of claims 1 to 5 on the support.

7. A method for forming a resist pattern, the method comprising:
a step of forming a photosensitive layer using the photosensitive resin composition according to any one of claims 1 to 5 or the photosensitive element according to claim 6, on a substrate;
a step of irradiating at least a part of the photosensitive layer with an active light ray to form a photo-cured area; and
a step of removing a non-photo-cured area of the photosensitive layer from the substrate to form a resist pattern.

8. A method for producing a printed wiring board, the method comprising a step of subjecting a substrate having a resist pattern formed by the method for forming a resist pattern according to claim 7 to an etching treatment or a plating treatment to form a conductor pattern.

9. The method for producing a printed wiring board according to claim 8, further comprising a step of removing the resist pattern after the etching treatment or the plating treatment.
